# EUROPEAN PATENT APPLICATION

(11) **EP 3 879 702 A1**
(43) Date of publication of application: **15.09.2021**
(21) Application number: 20161740.4
(22) Date of filing: 09.03.2020
(51) Int. Cl.: H03G 3/32, H03G 7/00

(54) **ADJUSTING A VOLUME LEVEL**

(71) Applicant: Nokia Technologies Oy, 02610 Espoo (FI)
(72) Inventor: LEPPÄNEN, Jussi Artturi, 33580 Tampere (FI); LAAKSONEN, Lasse Juhani, 33210 Tampere (FI); LEHTINIEMI, Arto Juhani, 33880 Lempäälä (FI); VILERMO, Miikka Tapani, 37200 Siuro (FI)
(74) Representative: Nokia EPO representatives

(57) **Abstract**

An apparatus, method and computer program product for: providing spatial audio information at a defined output volume level, the spatial audio information comprising at least a first audio signal and a second audio signal, receiving a user input for concurrently adjusting a volume level of the first audio signal and a volume level of the second audio signal, determining a type of the user input, and adjusting, based on the type of the user input, the volume level of the first audio signal and the volume level of the second audio signal while maintaining the defined output volume level.

## Description

### TECHNICAL FIELD

The present application relates generally to adjusting a volume level of an audio signal. More specifically, the present application relates to adjusting a volume level of a first audio signal and a volume level of a second audio signal.

### BACKGROUND

The amount of multimedia content increases continuously. Users create and consume multimedia content, and it has a big role in modern society.

### SUMMARY

Various aspects of examples of the invention are set out in the claims. The scope of protection sought for various embodiments of the invention is set out by the independent claims. The examples and features, if any, described in this specification that do not fall under the scope of the independent claims are to be interpreted as examples useful for understanding various embodiments of the invention.

According to a first aspect of the invention, there is provided an apparatus comprising means for providing spatial audio information at a defined output volume level, the spatial audio information comprising at least a first audio signal and a second audio signal, means for receiving a user input for concurrently adjusting a volume level of the first audio signal and a volume level of the second audio signal, means for determining a type of the user input, and means for adjusting, based on the type of the user input, the volume level of the first audio signal and the volume level of the second audio signal while maintaining the defined output volume level.

According to a second aspect of the invention, there is provided a method comprising: providing spatial audio information at a defined output volume level, the spatial audio information comprising at least a first audio signal and a second audio signal, receiving a user input for concurrently adjusting a volume level of the first audio signal and a volume level of the second audio signal, determining a type of the user input, and adjusting, based on the type of the user input, the volume level of the first audio signal and the volume level of the second audio signal while maintaining the defined output volume level.

According to a third aspect of the invention, there is provided a computer program comprising instructions for causing an apparatus to perform at least the following: providing spatial audio information at a defined output volume level, the spatial audio information comprising at least a first audio signal and a second audio signal, receiving a user input for concurrently adjusting a volume level of the first audio signal and a volume level of the second audio signal, determining a type of the user input, and adjusting, based on the type of the user input, the volume level of the first audio signal and the volume level of the second audio signal while maintaining the defined output volume level.

According to a fourth aspect of the invention, there is provided an apparatus comprising at least one processor and at least one memory including computer program code, the at least one memory and the computer program code configured to with the at least one processor, cause the apparatus at least to: provide spatial audio information at a defined output volume level, the spatial audio information comprising at least a first audio signal and a second audio signal, receive a user input for concurrently adjusting a volume level of the first audio signal and a volume level of the second audio signal, determine a type of the user input, and adjust, based on the type of the user input, the volume level of the first audio signal and the volume level of the second audio signal while maintaining the defined output volume level.

According to a fifth aspect of the invention, there is provided a non-transitory computer readable medium comprising program instructions for causing an apparatus to perform at least the following: providing spatial audio information at a defined output volume level, the spatial audio information comprising at least a first audio signal and a second audio signal, receiving a user input for concurrently adjusting a volume level of the first audio signal and a volume level of the second audio signal, determining a type of the user input, and adjusting, based on the type of the user input, the volume level of the first audio signal and the volume level of the second audio signal while maintaining the defined output volume level.

According to a sixth aspect of the invention, there is provided a computer readable medium comprising program instructions for causing an apparatus to perform at least the following: providing spatial audio information at a defined output volume level, the spatial audio information comprising at least a first audio signal and a second audio signal, receiving a user input for concurrently adjusting a volume level of the first audio signal and a volume level of the second audio signal, determining a type of the user input, and adjusting, based on the type of the user input, the volume level of the first audio signal and the volume level of the second audio signal while maintaining the defined output volume level.

### BRIEF DESCRIPTION OF THE DRAWINGS

Some example embodiments will now be described with reference to the accompanying drawings:
Figure 1 shows a block diagram of an example apparatus in which examples of the disclosed embodiments may be applied;
Figure 2 shows a block diagram of another example apparatus in which examples of the disclosed embodiments may be applied;
Figure 3 illustrate an example of a control element;
Figure 4 illustrate another example of a control element;
Figure 5 illustrate yet another example of a control element;
Figures 6A and 6B illustrate an example of adjusting a volume level of spatial audio; and
Figure 7 illustrates an example method.

### DETAILED DESCRIPTION

The following embodiments are exemplifying. Although the specification may refer to "an", "one", or "some" embodiment(s) in several locations of the text, this does not necessarily mean that each reference is made to the same embodiment(s), or that a particular feature only applies to a single embodiment. Single features of different embodiments may also be combined to provide other embodiments.

Example embodiments relate to an apparatus configured to adjust respective volume levels of a first audio signal and a second audio signal.

Some example embodiments relate to an apparatus configured to provide spatial audio information at a defined output volume level, the spatial audio information comprising at least a first audio signal and a second audio signal, receive a user input for concurrently adjusting a volume level of the first audio signal and a volume level of the second audio signal, determine a type of the user input, and adjust, based on the type of the user input, the volume level of the first audio signal and the volume level of the second audio signal while maintaining the defined output volume level.

Some example embodiments relate to an apparatus comprising an audio codec. An audio codec is a codec that is configured to encode and/or decode audio signals. An audio codec may comprise, for example, a speech codec that is configured to encode and/or decode speech signals. In practice, an audio codec comprises a computer program implementing an algorithm that compresses and decompresses digital audio data. For transmission purposes, the aim of the algorithm is to represent high-fidelity audio signal with minimum number of bits while retaining quality. In that way, storage space and bandwidth required for transmission of an audio file may be reduced.

Different audio codecs may have different bit rates. A bit rate refers to the number of bits that are processed or transmitted over a unit of time. Typically, a bit rate is expressed as a number of bits or kilobits per second (e.g., kbps or kbits/second). A bit rate may comprise a constant bit rate (CBR) or a variable bit rate (VBR). CBR files allocate a constant amount of data for a time segment while VBR files allow allocating a higher bit rate, that is more storage space, to be allocated to the more complex segments of media files and allocating a lower bit rate, that is less storage space, to be allocated to less complex segments of media files. A VBR operation may comprise discontinuous transmission (DTX) that may be used in combination with CBR or VBR operation. In DTX operation, parameters may be updated selectively to describe, for example, a background noise level and/or spectral noise characteristics during inactive periods such as silence, whereas regular encoding may be used during active periods such as speech.

There are different kinds of audio/speech codecs, for example, an enhanced voice services (EVS) codec suitable for improved telephony and teleconferencing, audiovisual conferencing services and streaming audio. Another example codec is an immersive voice and audio services (IVAS) codec. An aim of the IVAS codec is to provide support for real-time conversational spatial voice, multi-stream teleconferencing, virtual reality (VR) conversational communications and/or user generated live and on-demand content streaming. Conversational communication may comprise, for example, real-time two-way audio between a plurality of users. An IVAS codec provides support for, for example, from mono to stereo to fully immersive audio encoding, decoding and/or rendering. An immersive service may comprise, for example, immersive voice and audio for virtual reality (VR) or augmented reality (AR), and a codec may be configured to handle encoding, decoding and rendering of speech, music and generic audio. A codec may also support channel-based audio, object-based audio and/or scene-based audio.

Channel-based audio may, for example, comprise creating a soundtrack by recording a separate audio track (channel) for each loudspeaker or panning and mixing selected audio tracks between at least two loudspeaker channels. Common loudspeaker arrangements for channel-based surround sound systems are 5.1 and 7.1, which utilize five and seven surround channels, respectively, and one low-frequency channel. A drawback of channel-based audio is that each soundtrack is created for a specific loudspeaker configuration such as 2.0 (stereo), 5.1 and 7.1.

Object-based audio addresses this drawback by representing an audio field as a plurality of separate audio objects, each audio object comprising one or more audio signals and associated metadata. An audio object may be associated with metadata that defines a location or trajectory of that object in the audio field. Object-based audio rendering comprises rendering audio objects into loudspeaker signals to reproduce the audio field. As well as specifying the location and/or movement of an object, the metadata may also define the type of object, for example, acoustic characteristics of an object, and/or the class of renderer that is to be used to render the object. For example, an object may be identified as being a diffuse object or a point source object. Object-based renderers may use the positional metadata with a rendering algorithm specific to the particular object type to direct sound objects based on knowledge of loudspeaker positions of a loudspeaker configuration.

Scene-based audio combines the advantages of object-based and channel-based audio and it is suitable for enabling truly immersive VR audio experience. Scene-based audio comprises encoding and representing three-dimensional (3D) sound fields for a fixed point in space. Scene-based audio may comprise, for example, ambisonics and parametric immersive audio. Ambisonics comprises a full-sphere surround sound format that in addition to a horizontal plane comprises sound sources above and below a listener. Ambisonics may comprise, for example, first-order ambisonics (FOA) comprising four channels or higher-order ambisonics (HOA) comprising more than four channels such as 9, 16, 25, 36, or 49 channels. Parametric immersive audio may comprise, for example, metadata-assisted spatial audio (MASA).

Spatial audio may comprise a full sphere surround-sound to mimic the way people perceive audio in real life. Spatial audio may comprise audio that appears from a user's position to be assigned to a certain direction and/or distance. Therefore, the perceived audio may change with the movement of the user or with the user turning. Spatial audio may comprise audio created by sound sources, ambient audio or a combination thereof. Ambient audio may comprise audio that might not be identifiable in terms of a sound source such as traffic humming, wind or waves, for example. The full sphere surround-sound may comprise a spatial audio field and the position of the user or the position of the capturing device may be considered as a reference point in the spatial audio field. According to an example embodiment, a reference point comprises the centre of the audio field.

As mentioned above, conversational communication may comprise, for example, real-time two-way audio between a plurality of users. When spatial audio information comprises a plurality of signals, a user may need to control volume level of plurality of audio signals. However, providing a separate volume control for each audio signal may not be possible as, for example, a mobile computing device typically already has a plurality of volume controls for controlling ringtone volume level, media volume levels or the like. Adding more volume controls may be confusing for the user, especially if a different volume controls are provided for a same thing such as a volume control for controlling a call volume in a regular voice call and a volume control for controlling a call volume in an immersive voice call.

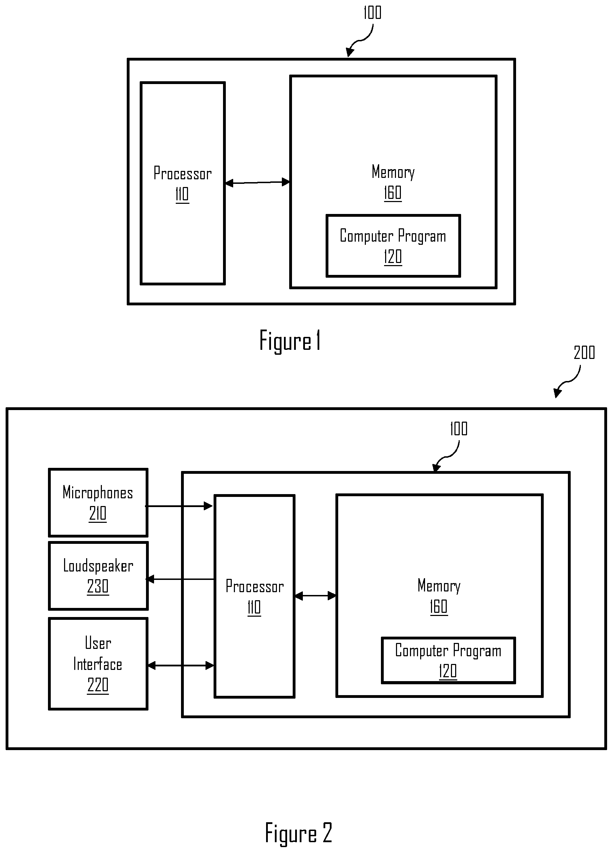

Figure 1 is a block diagram depicting an apparatus 100 operating in accordance with an example embodiment of the invention. The apparatus 100 may be, for example, an electronic device such as a chip or a chipset. The apparatus 100 comprises one or more control circuitry, such as at least one processor 110 and at least one memory 160, including one or more algorithms such as computer program code 120 wherein the at least one memory 160 and the computer program code are 120 configured, with the at least one processor 110 to cause the apparatus 100 to carry out any of example functionalities described below.

In the example of Figure 1, the processor 110 is a control unit operatively connected to read from and write to the memory 160. The processor 110 may also be configured to receive control signals received via an input interface and/or the processor 110 may be configured to output control signals via an output interface. In an example embodiment the processor 110 may be configured to convert the received control signals into appropriate commands for controlling functionalities of the apparatus 100.

The at least one memory 160 stores computer program code 120 which when loaded into the processor 110 control the operation of the apparatus 100 as explained below. In other examples, the apparatus 100 may comprise more than one memory 160 or different kinds of storage devices.

Computer program code 120 for enabling implementations of example embodiments of the invention or a part of such computer program code may be loaded onto the apparatus 100 by the manufacturer of the apparatus 100, by a user of the apparatus 100, or by the apparatus 100 itself based on a download program, or the code can be pushed to the apparatus 100 by an external device. The computer program code 120 may arrive at the apparatus 100 via an electromagnetic carrier signal or be copied from a physical entity such as a computer program product, a memory device or a record medium such as a Compact Disc (CD), a Compact Disc Read-Only Memory (CD-ROM), a Digital Versatile Disk (DVD) or a Blu-ray disk.

Figure 2 is a block diagram depicting an apparatus 200 in accordance with an example embodiment of the invention. The apparatus 200 may be an electronic device such as a hand-portable device, a mobile phone or a Personal Digital Assistant (PDA), a Personal Computer (PC), a laptop, a desktop, a tablet computer, a wireless terminal, a communication terminal, a game console, a music player, an electronic book reader (e-book reader), a positioning device, a digital camera, a household appliance, a CD-, DVD or Blu-ray player, or a media player. In the examples below it is assumed that the apparatus 200 is a mobile computing device or a part of it.

In the example embodiment of Figure 2, the apparatus 200 is illustrated as comprising the apparatus 100, a plurality of microphones 210, one or more loudspeakers 230 and a user interface 220 for interacting with the apparatus 200 (e.g. a mobile computing device). The apparatus 200 may also comprise a display configured to act as a user interface 220. For example, the display may be a touch screen display. In an example embodiment, the display and/or the user interface 220 may be external to the apparatus 200, but in communication with it.

Additionally or alternatively, the user interface 220 may also comprise a manually operable control such as a button, a key, a touch pad, a joystick, a stylus, a pen, a roller, a rocker, a keypad, a keyboard or any suitable input mechanism for inputting and/or accessing information. Further examples include a camera, a speech recognition system, eye movement recognition system, acceleration-, tilt- and/or movement-based input systems. Therefore, the apparatus 200 may also comprise different kinds of sensors such as one or more gyro sensors, accelerometers, magnetometers, position sensors and/or tilt sensors.

The apparatus 200 may be configured to establish radio communication with another device using, for example, a Bluetooth, WiFi, radio frequency identification (RFID), or a near field communication (NFC) connection. For example, the apparatus 200 may be configured to establish radio communication with a wireless headphone, augmented/virtual reality device or the like.

According to an example embodiment, the apparatus 200 comprises an audio codec comprising a decoder for decompressing received data such as an audio stream and/or an encoder for compressing data for transmission. According to an example embodiment, the audio codec is configured to support transmission of separate audio objects and ambient audio.

According to an example embodiment, the apparatus 200 is configured to provide spatial audio information at a defined output volume level, the spatial audio information comprising at least a first audio signal and a second audio signal. The spatial audio information may comprise, for example, spatial audio transmitted to the apparatus 200 during a voice or video call. The spatial audio information may comprise a plurality of audio components. An audio component may comprise a component that can be controlled independent of other audio components. An audio component may comprise, for example, an audio object comprising speech signals representative of speech of a caller, streamed audio signals, ambient audio signals or the like.

Providing spatial audio information may comprise, for example, causing rendering the spatial audio information by causing output of the spatial audio information via at least one loudspeaker. The apparatus may be configured to provide the spatial audio information during a voice or video call.

According to an example embodiment, the defined output volume level comprises a defined output volume level of a combination of the first audio signal and the second audio signal. The defined output volume level may comprise, for example, a volume level caused by outputting the first audio signal and the second audio signal at least partially concurrently. According to an example embodiment, the defined output volume level comprises a defined output volume level of the spatial audio information comprising at least the first audio signal and the second audio signal output via at least one loudspeaker for a user. A volume level may comprise a decibel value of output audio information.

According to an example embodiment, the first audio signal comprises an audio object. According to an example embodiment, the audio object comprises audio data associated with metadata. Metadata associated with an audio object provides information on the audio data. Information on the audio data may comprise, for example, one or more properties of the audio data, one or more characteristics of the audio data and/or identification information relating to the audio data. For example, metadata may provide information on a position associated with the audio data in a spatial audio field, movement of the audio object in the spatial audio field and/or a function of the audio data.

According to an example embodiment, the audio object comprises a spatial audio object comprising one or more audio signals and associated metadata that defines a location and/or trajectory of the audio object in a spatial audio field.

Without limiting the scope of the claims, an advantage of an audio object is that metadata may be associated with audio signals such that the audio signals may be reproduced by defining their position in a spatial audio field.

According to an example embodiment, the second audio signal comprises an ambient audio signal. According to another example embodiment, the second audio signal comprises an audio object.

According to an example embodiment, the apparatus 200 is configured to receive a user input for concurrently adjusting a volume level of the first audio signal and a volume level of the second audio signal. Adjusting a volume level may comprise changing the volume level by increasing or decreasing the volume level. According to an example embodiment, the apparatus 200 is configured to adjust a volume level by adjusting the output level of the volume.

A user input for concurrently adjusting a volume level of the first audio signal and the second audio signal comprises a user input concurrently affecting the volume level of the first audio signal and the volume level of the second audio signal. According to an example embodiment, the user input for concurrently adjusting a volume level of the first audio signal and a volume level of the second audio signal comprises a single user input.

According to an example embodiment, the apparatus 200 is configured to determine a type of the user input. According to an example embodiment, the apparatus 200 is configured to determine a type of the user input based on one or more characteristics of the user input. The one or more characteristics of the user input may comprise, for example, a duration of the user input, a length of the user input, a pressure caused by the user input, a trajectory of the user input, a shape of the user input or a combination thereof.

According to an example embodiment, a type of the user input comprises a gesture input. A gesture input may comprise a touch gesture input, a motion gesture input, a hover gesture input, or the like. A touch gesture input may comprise, for example, touching a touch screen or a touch pad using one or more fingers. A motion gesture input may comprise, for example, moving the apparatus 200 in a predetermined manner. A hover gesture input may comprise, for example, performing a gesture in close proximity of a device without touching the device.

According to an example embodiment, the type of the user input comprises a multi-finger gesture. A multi-finger gesture may comprise a multi-finger touch gesture or a multi-finger hover gesture.

According to an example embodiment the multi-finger gesture comprises a spread gesture, a pinch gesture or a rotate gesture. According to an example embodiment, a spread gesture comprises touching a touch screen or a touch pad with two fingers and moving them apart. According to an example embodiment, a pinch gesture comprises touching a touch screen or a touch pad with two fingers and bringing them closer together. According to an example embodiment, a rotate gesture comprises touching a touch screen or a touch pad with two fingers and rotating them in a clockwise or in a counterclockwise direction.

According to an example embodiment, the apparatus 200 is configured to adjust, based on the type of the user input, the volume level of the first audio signal and the volume level of the second audio signal while maintaining the defined output volume level. Maintaining the defined output volume level may comprise maintaining the exact volume level, maintaining an approximate volume level, maintaining the volume level within a predefined range of volume levels, maintaining the volume level such that the volume level appears for a user as substantially the same volume level, or the like.

Adjusting the volume level of the first audio signal and the volume level of the second audio signal may comprise increasing the volume level of the first audio signal and decreasing the volume level of the second audio signal, or decreasing the volume level of the first audio signal and increasing the volume level of the second audio signal. Thereby, adjusting the volume level of the first audio signal and the volume level of the second audio signal while maintaining the defined output volume level may comprise adjusting the volume levels of the first audio signal and the second audio signal with respect to each other. The volume levels of the first audio signal and the second audio signal may be adjusted at least partially concurrently. For example, the volume levels of the first audio signal and the second audio signal may be adjusted when a gesture input is active.

According to an example embodiment, the apparatus 200 is configured to increase the volume level of the first audio signal and decrease the volume level of the second audio signal in response to determining that the type of the user input comprises a spread gesture. According to another example embodiment, the apparatus 200 is configured to increase the volume level of the second audio signal and decrease the volume level of the first audio signal in response to determining that the type of the user input comprises a spread gesture.

According to an example embodiment, the apparatus 200 is configured to decrease the volume level of the first audio signal and increase the volume level of the second audio signal in response to determining that the type of the user input comprises a pinch gesture. According to an example embodiment, the apparatus 200 is configured to decrease the volume level of the second audio signal and increase the volume level of the first audio signal in response to determining that the type of the user input comprises a pinch gesture.

According to an example embodiment, the apparatus 200 is configured to set the volume level of the first audio signal to the volume level of the second audio signal and set the volume level of the second audio signal to the volume level of the first audio signal in response to determining that the type of the user input comprises a rotate gesture.

The apparatus 200 may also be configured to adjust the defined outputvolume level of spatial audio information. According to an example embodiment, the apparatus 200 is configured to adjust the defined output volume level based on the type of the user input. According to an example embodiment, the apparatus 200 is configured to adjust the defined output volume level of the spatial audio information while maintaining the relative volume levels of the first audio signal and the second audio signal.

According to an example embodiment, the apparatus 200 is configured to adjust the defined output volume level in response to determining that the type of the user input comprises a single-finger gesture.

According to an example embodiment, the apparatus 200 is configured to adjust the defined outputvolume level while maintaining the relative volume levels of the first audio signal and the second audio signal. For example, the apparatus 200 may be configured to increase, in response to determining that the type of the user input is a swipe gesture, the defined output volume level while maintaining the relative volume levels of the first audio signal and the second audio signal.

The user input may be provided on a control element. According to an example embodiment, the apparatus 200 is configured to provide a control element on a user interface for concurrently adjusting the volume levels of the first audio signal and the volume level of the second audio signal. The apparatus 200 may be configured to provide the control element on the user interface as horizontally aligned, vertically aligned or at a specific angle with respect to the user interface.

According to an example embodiment, the control element comprises a first component and a second component. The apparatus 200 may be configured to control the volume level of the first audio signal and the volume level of the second audio signal while maintaining the defined output volume level in response to determining that a user input is received on the first component. The apparatus 200 may further be configured to control the defined output volume level while maintaining the respective volume levels of the first audio signal and the second audio signal in response to determining that a user input is received on the second component. As another example, the apparatus 200 may be configured to control the volume level of the first audio signal and the volume level of the second audio signal while maintaining the defined output volume level in response to determining that a user input is received on the second component and control the defined output volume level while maintaining the respective volume levels of the first audio signal and the second audio signal in response to determining that a user input is received on the first component.

The first component may comprise, for example, a static component such as a volume control slider and the second component may comprise, for example, a dynamic component such as a handle moveable with respect to the static component. As another example, the first component may comprise a dynamic a component moveable with respect to a static component and the second component may comprise the static component.

According to an example embodiment, the control element comprises a volume control slider on a graphical user interface. According to an example embodiment, the volume control slider comprises a moveable handle for controlling the defined output volume level. According to an example embodiment, a position of the handle on the volume control slider indicates the defined output volume level.

According to an example embodiment, the apparatus 200 comprises means for performing the features of the claimed invention, wherein the means for performing comprises at least one processor 110, at least one memory 160 including computer program code 120, the at least one memory 160 and the computer program code 120 configured to, with the at least one processor 110, cause the performance of the apparatus 200. The means for performing the features of the claimed invention may comprise means for providing spatial audio information at a defined output volume level, the spatial audio information comprising at least a first audio signal and a second audio signal, means for receiving a user input for concurrently adjusting a volume level of the first audio signal and a volume level of the second audio signal, means for determining a type of the user input, and means for adjusting, based on the type of the user input, the volume level of the first audio signal and the volume level of the second audio signal while maintaining the defined output volume level.

The apparatus 200 may further comprise means for increasing the volume level of the first audio signal and decreasing the volume level of the second audio signal in response to determining that the type of the user input comprises a spread gesture, means for decreasing the volume level of the first audio signal and increasing the volume level of the second audio signal in response to determining that the type of the user input comprises a pinch gesture and/or means for setting the volume level of the first audio signal to the volume level of the second audio signal and setting the volume level of the second audio signal to the volume level of the first audio signal in response to determining that the type of the user input comprises a rotate gesture.

The apparatus may further comprise means for adjusting the defined output volume level based on the type of the user input. The apparatus 200 may comprise means for adjusting the defined output volume level in response to determining that the type of the user input comprises a single-finger gesture, means for adjusting the defined output volume level while maintaining the relative volume levels of the first audio signal and the second audio signal, and/or means for providing a control element on a user interface for concurrently adjusting the volume level of the first audio signal and the volume level of the second audio signal.

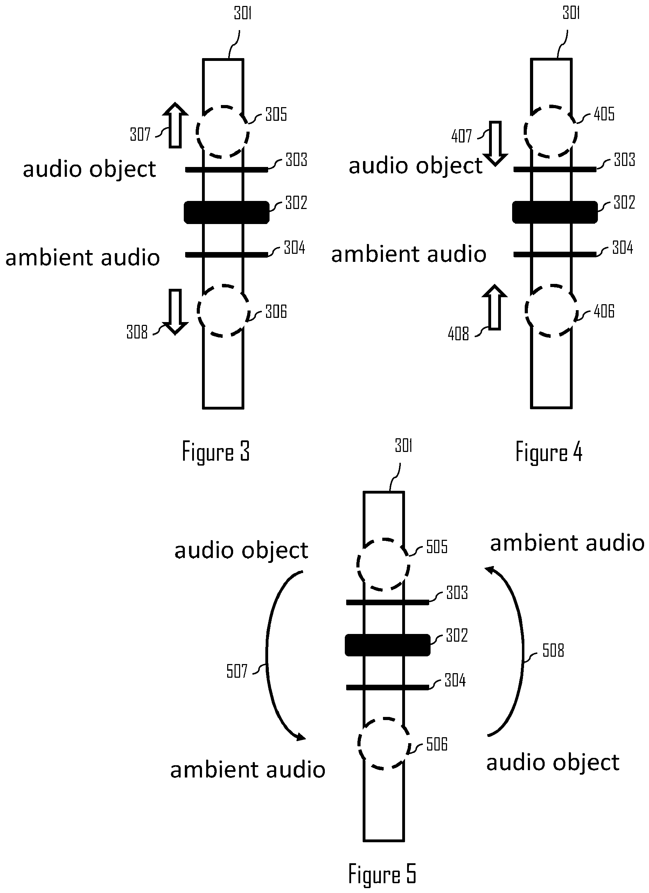

Figure 3 illustrates an example of a vertically aligned control element for adjusting a volume level of a first audio signal and a volume level of a second audio signal. The apparatus 200 is configured to receive a user input on the control element and control the volume level of the first audio signal and the volume level of the second audio signal based on the user input. The control element may be provided by the apparatus 200 on a user interface. In the example of Figure 3, the first audio signal comprises an audio object such as speech signals and the second audio signal comprises an ambient audio signal.

In the example of Figure 3, the control element comprises a slider area 301 and a moveable handle 302. A position of the moveable handle 302 on the slider area indicates a defined output volume level of spatial audio information comprising the first audio signal and the second audio signal. In the example of Figure 3, the defined output volume level 302 comprises a combined volume level of at least the first audio signal and the second audio signal.

The volume level of the first audio signal is indicated by a volume level indicator 303 and the volume level of the second audio signal is indicated by a volume level indicator 304. The higher a volume level indicator is on the slider area 301, the higher the volume is. For example, in Figure 3, the volume level of the first audio signal is higher than the volume level of the second audio signal. In case of a horizontally aligned control element, for example, the more right the volume level indicator is on the slider area, the higher the volume is.

The apparatus 200 is configured to receive a user input for concurrently adjusting a volume level of the first audio signal and a volume level of the second audio signal. In the example of Figure 3, the user input comprises a spread gesture on the slider area 301 where a first finger 305 and a second finger 306 touch the slider area 301 and are then moved apart as indicated by arrows 307 and 308, respectively. Therefore, in response to determining that the type of the user input comprises a spread gesture, the apparatus 200 is configured to increase the volume level of the first audio signal and the volume level of the second audio signal while maintaining the defined output volume level.

Without limiting the scope of the claims, an advantage of increasing the volume level of the first audio signal and the volume level of the second audio signal in response to a spread gesture is that the gesture is intuitive for the user as the gesture comprises a moving fingers apart similarly to making the volume level apart from each other.

Figure 4 illustrates another example of a vertically aligned control element for adjusting a volume level of a first audio signal and a volume level of a second audio signal. The apparatus 200 is configured to receive a user input on the control element and control the volume level of the first audio signal and the volume level of the second audio signal based on the user input. The control element may be provided by the apparatus 200 on a user interface. Similarly to the example of Figure 3, the first audio signal comprises an audio object such as human voice and the second audio signal comprises an ambient audio signal.

Similarly to the example of Figure 3, the control element comprises a slider area 301 and a moveable handle 302. A position of the moveable handle 302 on the slider area indicates the defined output volume level of spatial audio information comprising the first audio signal and the second audio signal. In the example of Figure 4, the defined output volume level 302 comprises a combined volume level of at least the first audio signal and the second audio signal.

The volume level of the first audio signal is indicated by a volume level indicator 303 and the volume level of the second audio signal is indicated by a volume level indicator 304. The higher a volume level indicator is on the slider area 301, the higher the volume is. For example, in Figure 4, the volume level of the first audio signal is higher than the volume level of the second audio signal. In case of a horizontally aligned control element, for example, the more right the volume level indicator is on the slider area, the higher the volume is.

The apparatus 200 is configured to receive a user input for concurrently adjusting a volume level of the first audio signal and a volume level of the second audio signal. In the example of Figure 4, the user input comprises a pinch gesture on the slider area 301 where a first finger 405 and a second finger 406 touch the slider area 301 and are then moved closer together as indicated by arrows 407 and 408, respectively. Therefore, in response to determining that the type of the user input comprises a pinch gesture, the apparatus 200 is configured to decrease the volume level of the first audio signal and the volume level of the second audio signal while maintaining the defined output volume level.

Without limiting the scope of the claims, an advantage of decreasing the volume level of the first audio signal and the volume level of the second audio signal in response to a pinch gesture is that the gesture is intuitive for the user as the gesture comprises a moving fingers closer together similarly to making the volume levels closer to each other.

Figure 5 illustrates yet another example of a vertically control element for adjusting a volume level of a first audio signal and a volume level of a second audio signal. The apparatus 200 is configured to receive a user input on the control element and control the volume level of the first audio signal and the volume level of the second audio signal based on the user input. The control element may be provided by the apparatus 200 on a user interface. Similarly to the examples of Figure 3 and Figure 4, the first audio signal comprises an audio object such as human voice and the second audio signal comprises an ambient audio signal.

In the example of Figure 5, the control element comprises a slider area 301 and a moveable handle 302. A position of the moveable handle 302 on the slider area indicates a defined output volume level of spatial audio information comprising the first audio signal and the second audio signal. Similarly to the examples of Figures 3 and 4, the defined output volume level 302 comprises a combined volume level of at least the first audio signal and the second audio signal.

The volume level of the first audio signal is indicated by a volume level indicator 303 and the volume level of the second audio signal is indicated by a volume level indicator 304. The higher a volume level indicator is on the slider area 301, the higher the volume is. For example, in Figure 5, the volume level of the first audio signal is higher than the volume level of the second audio signal. In case of a horizontally aligned control element, for example, the more right the volume level indicator is on the slider area, the higher the volume is.

The apparatus 200 is configured to receive a user input for concurrently adjusting a volume level of the first audio signal and a volume level of the second audio signal. In the example of Figure 5, the user input comprises a rotate gesture where a first finger and a second finger are rotated in a clockwise or counterclockwise direction as indicated by arrows 507 and 508. Therefore, in response to determining that the type of the user input comprises a rotate gesture, the apparatus 200 is configured to set the volume level of the first audio signal to the volume level of the second audio signal and setting the volume level of the second audio signal to the volume level of the first audio signal.

Without limiting the scope of the claims, an advantage of switching the first volume level to the second volume level and the second volume level to the first volume level in response to a rotate gesture is that the gesture is intuitive for the user as the gesture comprises a rotating fingers similarly to switching the volume levels of the first audio signal and the second audio signal.

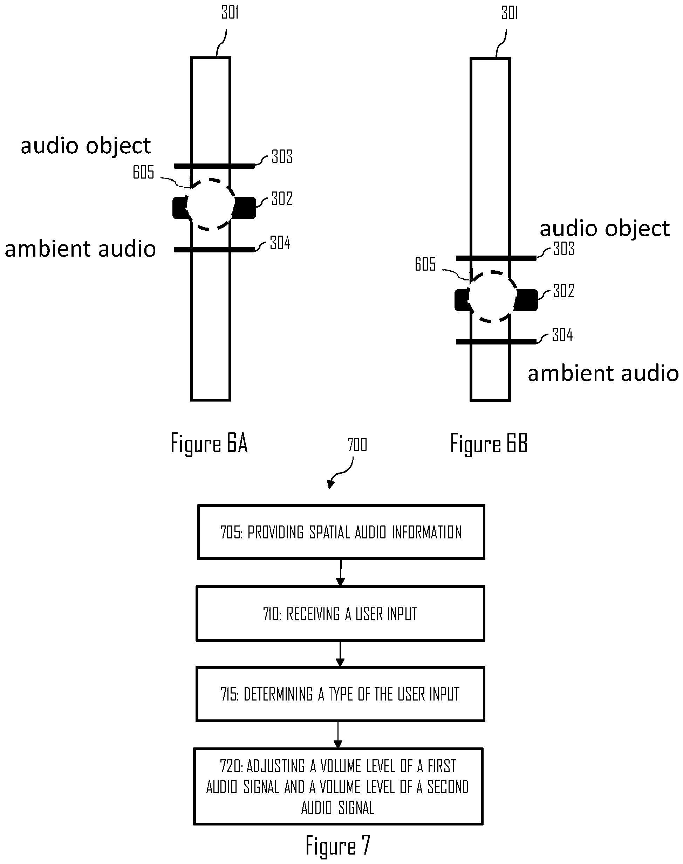

Figures 6A and 6B illustrate an example of adjusting the defined output volume level of spatial audio. In the example of Figure 6A, the apparatus 200 receives a single-finger user input 605 for adjusting the defined output volume level of spatial audio comprising the first audio signal and the second audio signal by adjusting the moveable handle 302. In the example of Figure 6B, the defined output volume level is lower than in the example of Figure 6A, thereby indicating that the defined output volume level is decreased. The apparatus 200 is configured to adjust the defined output volume while maintaining the respective volume levels of the first audio signal and the second audio signal.

Figure 7 illustrates an example method 700 incorporating aspects of the previously disclosed embodiments. More specifically the example method 700 illustrates adjusting a volume level of a first audio signal and a volume level of a second audio signal.

The method starts with providing 705 spatial audio information at a defined output volume level, the spatial audio information comprising at least a first audio signal and a second audio signal.

The method continues with receiving 710 a user input for concurrently adjusting a volume level of the first audio signal and a volume level of the second audio signal.

The method further continues with determining 715 a type of the user input. The user input may comprise a multi-finger input such as a spread gesture, a pinch gesture or a rotate gesture.

The method further continues with adjusting 720, based on the type of the user input, the volume level of the first audio signal and the volume level of the second audio signal while maintaining the defined output volume level.

Without limiting the scope of the claims, an advantage of adjusting a volume level of a first audio signal and a second audio signal while maintaining a defined output volume level of spatial audio may be that a user may pick particular audio signals in spatial audio that he wishes to hear louder without increasing or decreasing the defined output volume level. An advantage of a user input for concurrently adjusting a volume level of a first audio signal and a volume level of a second audio signal may be that a single input may be used for controlling a plurality of audio signals.

Without in any way limiting the scope, interpretation, or application of the claims appearing below, a technical effect of one or more of the example embodiments disclosed herein is that spatial audio may be controlled in a more efficient manner. Another technical effect of one or more of the example embodiments disclosed herein is that, for example, space on a user interface may be saved when there is no need to provide a plurality of control elements.

As used in this application, the term "circuitry" may refer to one or more or all of the following: (a) hardware-only circuit implementations (such as implementations in only analog and/or digital circuitry) and (b) combinations of hardware circuits and software, such as (as applicable): (i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions) and (c) hardware circuit(s) and or processor(s), such as a microprocessor(s) or a portion of a microprocessor(s), that requires software (e.g., firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

Embodiments of the present invention may be implemented in software, hardware, application logic or a combination of software, hardware and application logic. The software, application logic and/or hardware may reside on the apparatus, a separate device or a plurality of devices. If desired, part of the software, application logic and/or hardware may reside on the apparatus, part of the software, application logic and/or hardware may reside on a separate device, and part of the software, application logic and/or hardware may reside on a plurality of devices. In an example embodiment, the application logic, software or an instruction set is maintained on any one of various conventional computer-readable media. In the context of this document, a 'computer-readable medium' may be any media or means that can contain, store, communicate, propagate or transport the instructions for use by or in connection with an instruction execution system, apparatus, or device, such as a computer, with one example of a computer described and depicted in FIGURE 2. A computer-readable medium may comprise a computer-readable storage medium that may be any media or means that can contain or store the instructions for use by or in connection with an instruction execution system, apparatus, or device, such as a computer.

If desired, the different functions discussed herein may be performed in a different order and/or concurrently with each other. Furthermore, if desired, one or more of the above-described functions may be optional or may be combined.

Although various aspects of the invention are set out in the independent claims, other aspects of the invention comprise other combinations of features from the described embodiments and/or the dependent claims with the features of the independent claims, and not solely the combinations explicitly set out in the claims.

It will be obvious to a person skilled in the art that, as the technology advances, the inventive concept can be implemented in various ways. The invention and its embodiments are not limited to the examples described above but may vary within the scope of the claims.

## Claims

1. An apparatus comprising:
means for providing spatial audio information at a defined output volume level, the spatial audio information comprising at least a first audio signal and a second audio signal;
means for receiving a user input for concurrently adjusting a volume level of the first audio signal and a volume level of the second audio signal;
means for determining a type of the user input; and
means for adjusting, based on the type of the user input, the volume level of the first audio signal and the volume level of the second audio signal while maintaining the defined output volume level.

2. The apparatus according to claim 1, wherein the type of the user input comprises a multi-finger gesture.

3. The apparatus according to claim 2, wherein the multi-finger gesture comprises a spread gesture, a pinch gesture or a rotate gesture.

4. The apparatus according to claim 3, wherein the apparatus comprises means for increasing the volume level of the first audio signal and decreasing the volume level of the second audio signal in response to determining that the type of the user input comprises a spread gesture.

5. The apparatus according to claim 3, wherein the apparatus comprises means for decreasing the volume level of the first audio signal and increasing the volume level of the second audio signal in response to determining that the type of the user input comprises a pinch gesture.

6. The apparatus according to claim 3, wherein the apparatus comprises means for setting the volume level of the first audio signal to the volume level of the second audio signal and setting the volume level of the second audio signal to the volume level of the first audio signal in response to determining that the type of the user input comprises a rotate gesture.

7. The apparatus according to any preceding claim, wherein the apparatus further comprises means for adjusting the defined output volume level based on the type of the user input.

8. The apparatus according to claim 7, wherein the apparatus comprises means for adjusting the defined output volume level in response to determining that the type of the user input comprises a single-finger gesture.

9. The apparatus according to claim 7 or 8, wherein the apparatus further comprises means for maintaining the respective volume levels of the first audio signal and the second audio signal.

10. The apparatus according any preceding claim, wherein the first audio signal comprises an audio object.

11. The apparatus according to any preceding claim, wherein the second audio signal comprises an ambient audio signal.

12. The apparatus according to any preceding claim, wherein the apparatus further comprises means for providing a control element on a user interface for concurrently adjusting the volume levels of the first audio signal and the volume level of the second audio signal

13. The apparatus according to claim 12, wherein the control element comprises a volume control slider on a graphical user interface.

14. A method comprising:
providing spatial audio information at a defined output volume level, the spatial audio information comprising at least a first audio signal and a second audio signal;
receiving a user input for concurrently adjusting a volume level of the first audio signal and a volume level of the second audio signal;
determining a type of the user input; and
adjusting, based on the type of the user input, the volume level of the first audio signal and the volume level of the second audio signal while maintaining the defined output volume level.

15. A computer readable medium comprising instructions for causing an apparatus to perform at least the following:
providing spatial audio information at a defined output volume level, the spatial audio information comprising at least a first audio signal and a second audio signal;
receiving a user input for concurrently adjusting a volume level of the first audio signal and a volume level of the second audio signal;
determining a type of the user input; and
adjusting, based on the type of the user input, the volume level of the first audio signal and the volume level of the second audio signal while maintaining the defined output volume level.
